# EUROPEAN PATENT APPLICATION

(11) **EP 3 002 835 A1**
(43) Date of publication of application: **06.04.2016**
(21) Application number: 15187537.4
(22) Date of filing: 30.09.2015
(51) Int. Cl.: H01S 3/102, H01S 3/00, H01S 3/02, F02P 23/04, H01S 3/06, H01S 3/094, H01S 3/0941, H01S 3/113, H01S 5/42

(54) **LASER DEVICE, IGNITION SYSTEM, AND INTERNAL COMBUSTION ENGINE**

(30) Priority: 30.09.2014 JP 2014200635; 17.08.2015 JP 2015160476
(71) Applicant: Ricoh Company, Ltd., Tokyo 143-8555 (JP)
(72) Inventor: HAGITA, Kentaroh, Tokyo, 143-8555 (JP); SUZUDO, Tsuyoshi, Tokyo, 143-8555 (JP); HIGASHI, Yasuhiro, Tokyo, 143-8555 (JP); JIKUTANI, Naoto, Tokyo, 143-855 (JP); NUMATA, Masayuki, Tokyo, 143-8555 (JP); IZUMIYA, Kazuma, Tokyo, 143-8555 (JP)
(74) Representative: Maury, Richard Philip

(57) **Abstract**

A laser device (200) is provided including a light source (201) configured to emit light, a light transmission member (204) configured to transmit the light emitted from the light source (201), a plurality of optical elements (205) disposed in an optical path of the light transmitted by the light transmission member (204), a laser resonator (206) which the light passed through the plurality of optical elements (205) enter, and an adjuster (207) configured to adjust a position of at least one of the plurality of optical elements (205).

## Description

### BACKGROUND

### Technical Field

Embodiments of the present invention relate to a laser device, an ignition system, and an internal combustion engine.

### Background Art

Laser devices with laser crystal that resonates by optical pumping are expected to be applied to various kinds of fields including, for example, ignition systems, laser beam machines, and medical equipment.

For example, JP-2013-545280-A discloses a laser ignition system that includes a laser device and a pump source with a plurality of surface emitting lasers.

However, it has proven difficult for conventional laser devices to achieve desired laser characteristics in a stable manner.

### SUMMARY

Embodiments of the present invention described herein provide a laser device including a light source configured to emit light, a light transmission member configured to transmit the light emitted from the light source, a plurality of optical elements disposed in an optical path of the light transmitted by the light transmission member, a laser resonator which the light passed through the plurality of optical elements enter, and an adjuster configured to adjust a position of at least one of the plurality of optical elements.

With the laser device according to an embodiment of the present invention, desired laser characteristics can be achieved in a stable manner.

### BRIEF DESCRIPTION OF THE DRAWINGS

A more complete appreciation of exemplary embodiments and the many attendant advantages thereof will be readily obtained as the same becomes better understood by reference to the following detailed description when considered in connection with the accompanying drawings.
FIG. 1 is a diagram illustrating an outline of an engine according to an embodiment of the present invention.
FIG. 2 is a diagram illustrating an ignition system according to an example embodiment of the present invention.
FIG. 3 is a diagram illustrating a laser resonator according to an embodiment of the present invention.
FIG. 4 is a diagram illustrating a beam-waist diameter, an incidence angle, and the distance between a first surface to a focal point of the light that enters a laser resonator, according to an embodiment of the present invention.
FIG. 5 is diagram illustrating a second condensing optical system according to an embodiment of the present invention.
FIG. 6 is a diagram illustrating a positioning mechanism according to an example embodiment of the present invention.
FIG. 7A and FIG. 7B are a set of diagrams illustrating a spacer according to an embodiment of the present invention.
FIG. 8A and FIG. 8B are a set of diagrams illustrating a first method of shifting a first lens to the -Z side for adjustment with reference to a basic configuration, according to an example embodiment of the present invention.
FIG. 9A and FIG. 9B are a set of diagrams illustrating a second method of shifting a first lens to the -Z side for adjustment with reference to a basic configuration, according to an example embodiment of the present invention.
FIG. 10A and FIG. 10B are a set of diagrams illustrating a first method of shifting a first lens to the +Z side for adjustment with reference to a basic configuration, according to an example embodiment of the present invention.
FIG. 11A and FIG. 11B are a set of diagrams illustrating a second method of shifting a first lens to the +Z side for adjustment with reference to a basic configuration, according to an example embodiment of the present invention.
FIG. 12A and FIG. 12B are a set of diagrams illustrating a first method of shifting a second lens to the -Z side for adjustment with reference to a basic configuration, according to an example embodiment of the present invention.
FIG. 13A and FIG. 13B are a set of diagrams illustrating a second method of shifting a second lens to the -Z side for adjustment with reference to a basic configuration, according to an example embodiment of the present invention.
FIG. 14A and FIG. 14B are a set of diagrams illustrating a first method of shifting a second lens to the +Z side for adjustment with reference to a basic configuration, according to an example embodiment of the present invention.
FIG. 15A and FIG. 15B are a set of diagrams illustrating a second method of shifting a second lens to the +Z side for adjustment with reference to a basic configuration, according to an example embodiment of the present invention.
FIG. 16A and FIG. 16B are a set of diagrams illustrating a first method of shifting a laser resonator to the -Z side for adjustment with reference to a basic configuration, according to an example embodiment of the present invention.
FIG. 17A and FIG. 17B are a set of diagrams illustrating a second method of shifting a laser resonator to the -Z side for adjustment with reference to a basic configuration, according to an example embodiment of the present invention.
FIG. 18A and FIG. 18B are a set of diagrams illustrating a first method of shifting a laser resonator to the +Z side for adjustment with reference to a basic configuration, according to an example embodiment of the present invention.
FIG. 19A and FIG. 19B are a set of diagrams illustrating a second method of shifting a laser resonator to the +Z side for adjustment with reference to a basic configuration, according to an example embodiment of the present invention.
FIG. 20 is a diagram illustrating a first modification of a laser device according to an embodiment of the present invention.
FIG. 21 is a diagram illustrating a second modification of a laser device according to an embodiment of the present invention.

The accompanying drawings are intended to depict exemplary embodiments of the present disclosure and should not be interpreted to limit the scope thereof. The accompanying drawings are not to be considered as drawn to scale unless explicitly noted.

### DETAILED DESCRIPTION

The terminology used herein is for the purpose of describing particular embodiments only and is not intended to be limiting of the present invention. As used herein, the singular forms "a", "an" and "the" are intended to include the plural forms as well, unless the context clearly indicates otherwise. It will be further understood that the terms "includes" and/or "including", when used in this specification, specify the presence of stated features, integers, steps, operations, elements, and/or components, but do not preclude the presence or addition of one or more other features, integers, steps, operations, elements, components, and/or groups thereof.

In describing example embodiments shown in the drawings, specific terminology is employed for the sake of clarity. However, the present disclosure is not intended to be limited to the specific terminology so selected and it is to be understood that each specific element includes all technical equivalents that have the same structure, operate in a similar manner, and achieve a similar result.

### <General Outline>

In the following description, an embodiment of the present invention is described with reference to the drawings.

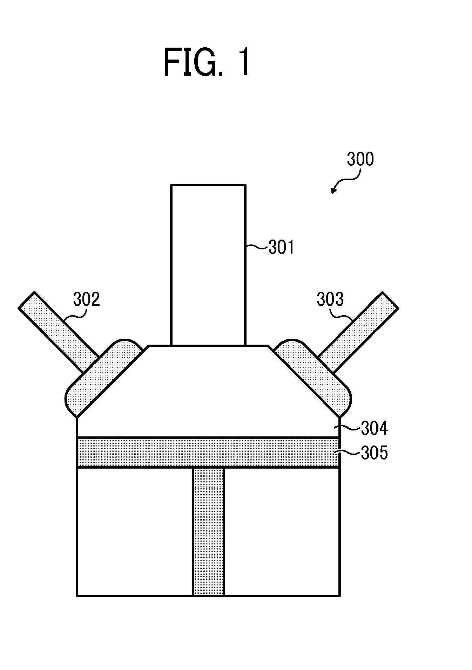

FIG. 1 is a schematic diagram illustrating the principal parts of an engine 300 that serves as an internal combustion engine, according to an embodiment of the present invention.

The engine 300 includes, for example, an ignition system 301, a fuel injector 302, an exhauster 303, a combustion chamber 304, and a piston 305.

The operation of the engine 300 is briefly described.
(1) The fuel injector 302 injects the inflammable fuel-air mixture into the combustion chamber 304 (aspiration).
(2) The piston 305 moves upward and compresses the inflammable fuel-air mixture (compression).
(3) The ignition system 301 emits laser beam into the combustion chamber 304. Accordingly, the fuel is ignited (ignition).
(4) Inflammable gas is generated and the piston 305 moves downward (combustion).
(5) The exhauster 303 exhausts the inflammable gas from the combustion chamber 304 (exhaust).

As described above, a series of processes including aspiration, compression, ignition, combustion, and exhaust are repeated. Then, the piston 305 moves upward and downward according to the changes in the volume of the gas in the combustion chamber 304, and kinetic energy is produced. As fuel, for example, natural gas and gasoline are used.

Note that the above operation of the engine 300 is performed based on the instruction made through an engine controller that is externally provided and is electrically connected to the engine 300.

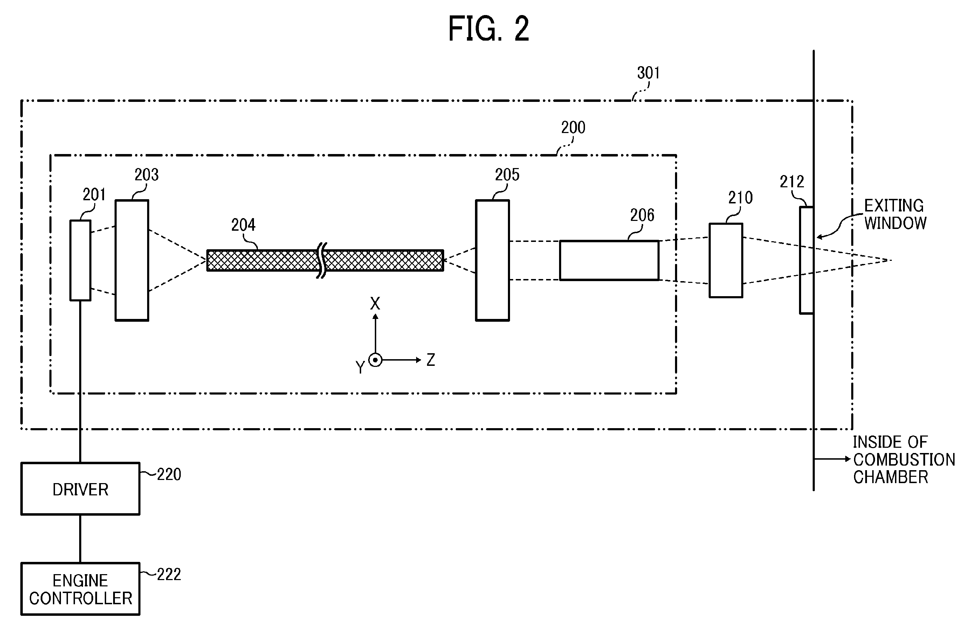

As illustrated in FIG. 2 for example, the ignition system 301 includes a laser device 200, an emission optical system 210, and a protector 212.

The emission optical system 210 collects and condenses the light emitted from the laser device 200. Accordingly, a high energy density can be obtained at a focal point.

The protector 212 is a transparent window facing toward the combustion chamber 304. In the present embodiment, for example, sapphire glass is used as a material of the protector 212.

The laser device 200 includes a surface emitting laser array 201, a first condensing optical system 203, an optical fiber 204, a second condensing optical system 205, and a laser resonator 206. In the XYZ three-dimensional orthogonal coordinate system according to the present embodiment, it is assumed that the direction in which the surface emitting laser array 201 emits light is the +X direction.

The surface emitting laser array 201 is a pump source, and includes a plurality of light-emitting units. Each of the light-emitting units is a vertical cavity-surface emitting laser (VCSEL).

Note that a surface emitting laser array has very little temperature-driven wavelength displacement in the emitting light. Thus, a surface emitting laser array is a light source that is advantageous in pumping Q-switched laser whose characteristics vary widely due to the displacement in pumping wavelength. Accordingly, when a surface emitting laser array is used as a pump source, the temperature control of the environment becomes easier.

The first condensing optical system 203 collects and condenses the light emitted from the surface emitting laser array 201.

The optical fiber 204 is disposed such that the light exited from the first condensing optical system 203 is condensed at the center of the -Z side lateral edge face of the core.

Due to the provision of the optical fiber 204, the surface emitting laser array 201 may be disposed at a position distant from the laser resonator 206. Accordingly, the degree of flexibility in design increases. As the surface emitting laser array 201 can be disposed at a position away from the heat source when the laser device 200 is used for an ignition system, the ranges of choices for a method for cooling the engine 300 can be extended.

The light that has entered the optical fiber 204 propagates through the core, and is exited from the +Z side lateral edge face of the core.

The second condensing optical system 205 is disposed in the optical path of the light emitted from the optical fiber 204, and condenses the light emitted from the optical fiber 204. The light that has been condensed by the second condensing optical system 205 enters the laser resonator 206.

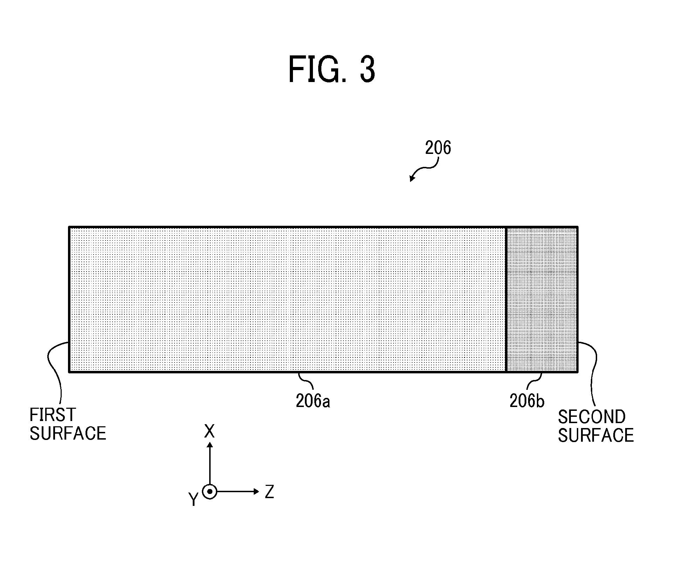

The laser resonator 206 is a Q-switched laser, and as illustrated in FIG. 3 for example, the laser resonator 206 includes a laser medium 206a and a saturable absorber 206b.

The laser medium 206a is a cuboid-shaped neodymium (Nd): yttrium aluminum garnet (YAG) crystal, where the length of the resonator is 8 mm. The saturable absorber 206b is a cuboid-shaped chromium (Cr): YAG crystal, where the length is 2 mm.

In the present embodiment, Nd: YAG crystal and Cr: YAG crystal are bonded together to form a so-called composite crystal. Moreover, the Nd: YAG crystal and the Cr: YAG crystal are both ceramic.

The light that has been condensed by the second condensing optical system 205 enters the laser medium 206a. In other words, the laser medium 206a is optically pumped by the light that has been condensed by the second condensing optical system 205. It is desired that the wavelength of the light that is emitted from the surface emitting laser array 201 be 808 nanometer (nm) where the absorption efficiency is the highest in the YAG crystal. The saturable absorber 206b performs Q-switching.

The surface on the light entering side (-Z side) of the laser medium 206a and the surface on the light exiting side (+Z side) of the saturable absorber 206b are optically polished, and each of these surfaces serves as a mirror. In the following description, for the sake of explanatory convenience, the surface on the light entering side of the laser medium 206a is referred to as a first surface, and the surface on the light exiting side of the saturable absorber 206b is referred to a second surface (see FIG. 3).

On the first and second surfaces, a dielectric layer is coated according to the wavelength of the light that is emitted from the surface emitting laser array 201 and the wavelength of the light that exits from the laser resonator 206.

More specifically, a dielectric layer that indicates sufficient high transmittance to light with the wavelength of 808 nm and indicates sufficiently high reflectance to light with the wavelength of 1064 nm is coated on the first surface. On the second surface, a dielectric layer with selected reflectance indicating a desired threshold to light with the wavelength of 1064 nm is coated.

Accordingly, the light is resonated and amplified inside the laser resonator 206. In the present embodiment, the length of the laser resonator 206 is 10 (=8+2) mm.

As illustrated in FIG. 2, the driver 220 drives the surface emitting laser array 201 based on an instruction from an engine controller 222. More specifically, the driver 220 drives the surface emitting laser array 201 such that the ignition system 301 emits light at the timing when the engine 300 performs ignition. Note that a plurality of light-emitting units of the surface emitting laser array 201 are switched on and switched off at the same time.

When it is not necessary to dispose the surface emitting laser array 201 at a position distant from the laser resonator 206 in the embodiments described above, the provision of the optical fiber 204 may be omitted.

Each of the first condensing optical system 203 and the emission optical system 210 may include only one lens or a plurality of lenses.

In the present embodiment, cases of an engine (piston engine) where a piston is moved by inflammable gas is used as an internal combustion engine have been described. However, no limitation is intended thereby. For example, a rotary engine, a gas turbine engine, and a jet engine may be used as an internal combustion engine. In other words, any engine may be used as long as it burns fuel to produce inflammable gas.

The ignition system 301 may be used for cogeneration in which exhaust heat is reused to increase the comprehensive energy efficiency. The exhaust heat in cogeneration is used for obtaining motive power, heating energy, or cooling energy.

In the present embodiment, cases in which the ignition system 301 is used for an internal combustion engine have been described. However, no limitation is intended thereby.

In the present embodiment, cases in which the laser device 200 is used for an ignition system have been described. However, no limitation is intended thereby. For example, the laser device 200 may be used for a laser beam machine, a laser peening apparatus, or a terahertz generator.

### <Details>

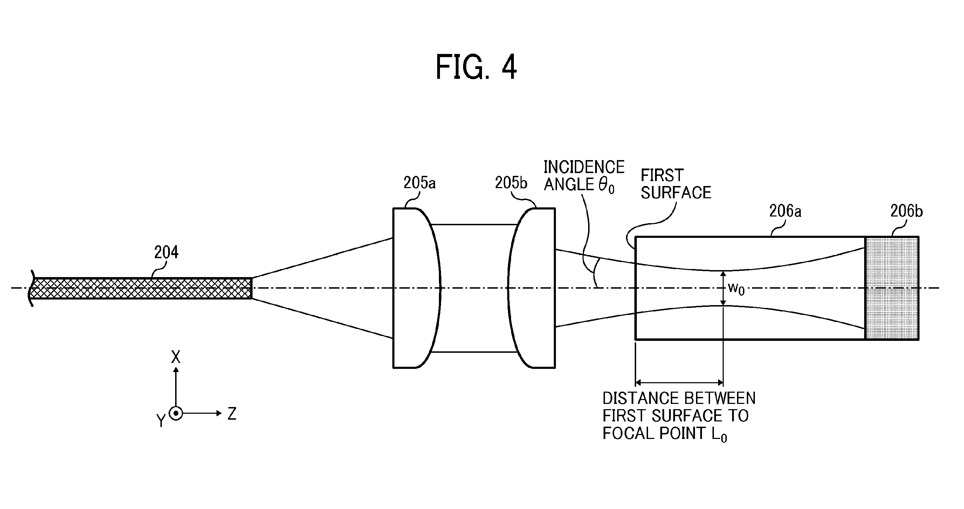

Note that the "beam-waist diameter", "incidence angle", and "distance between first surface to focal point" (see FIG. 4) of the light that enters the laser resonator 206, so-called incident-light characteristics, have a significant impact on the Q-switched laser characteristics. Moreover, the Q-switched laser characteristics change, for example, when the above-mentioned incident-light characteristics change due to an error in assembly.

Moreover, these light-emitting units of the surface emitting laser array 201 are disposed in an area having 8.9 mm diameter. When the surface emitting laser array 201 emits light, the multiple light-emitting units emit light at the same time.

The surface emitting laser array 201 includes a plurality of light-emitting units as described above, and thus the optical output can be increased. In the present embodiment, the optical output of the surface emitting laser array 201 is about 200 W.

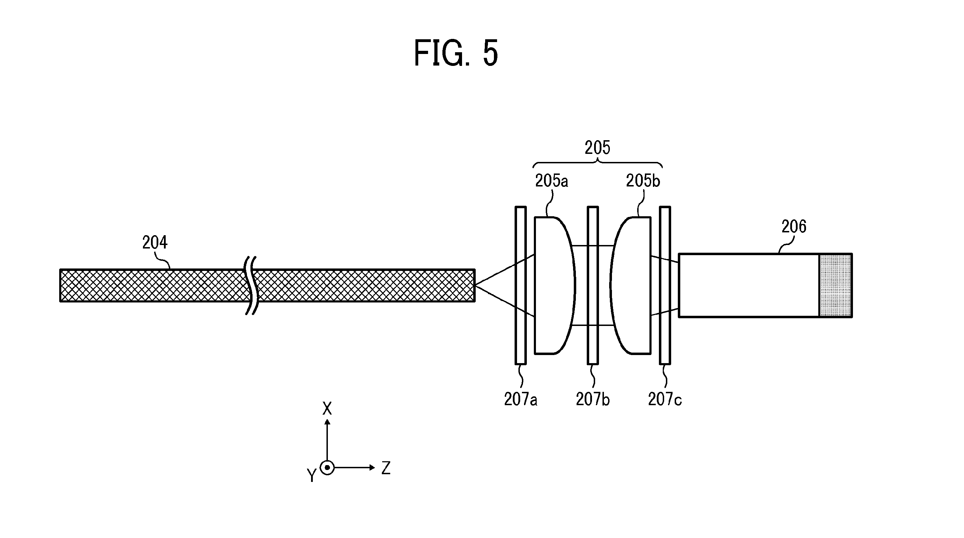

In the present embodiment, the second condensing optical system 205 includes a first lens 205a, a second lens 205b, and a plurality of spacers (207a to 207d) (see FIG. 5). Note that the second condensing optical system 205 may include three or more lenses.

The first lens 205a is a collimator lens that approximately collimates the light emitted from the optical fiber 204. In the present embodiment, a collimator lens where the focal length is 8 mm (manufactured by Thorlabs, inc., model number: C240TME-B) is used as the first lens 205a.

The second lens 205b is a condenser lens that approximately collects and condenses the light that is approximately collimated by the first lens 205. In the present embodiment, a condenser lens where the focal length is 6.24 mm (manufactured by Thorlabs, inc., model number: C110TME-B) is used as the second lens 205b.

Note that other kinds of lens may be used for the first lens 205a and the second lens 205b.

In the present embodiment, the incident-light characteristics can be controlled by adjusting the relative positions of the first lens 205a, the second lens 205b, and the laser resonator 206 in the Z-axis direction.

For example, the relative positions of at least one of the second lens 205b and the laser resonator 206 in the Z-axis direction are adjusted to control the "distance between first surface to focal point".

Moreover, the relative positions of at least one of the first lens 205a and the second lens 205b in the Z-axis direction are adjusted to control the "beam-waist diameter".

Further, the relative positions of at least one of the first lens 205a and the second lens 205b in the Z-axis direction are adjusted to control the "incidence angle".

In the present embodiment, the relative position of the first lens 205a is adjusted by at least one of the spacer 207a and the spacer 207b.

Moreover, the relative position of the second lens 205b is adjusted by at least one of the spacer 207b and the spacer 207c.

Further, the relative position of the laser resonator 206 is adjusted by at least one of the spacer 207c and the spacer 207d.

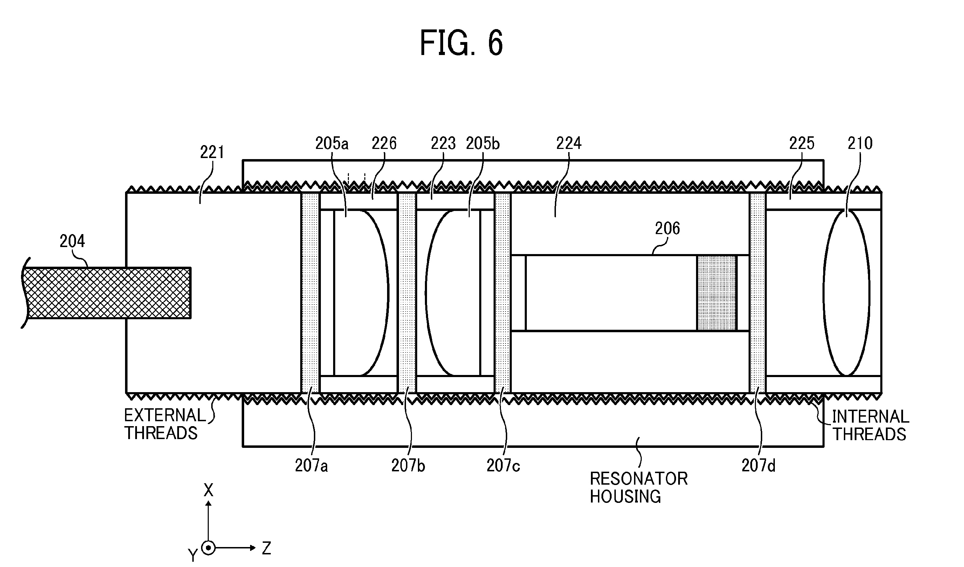

In the present embodiment, as illustrated in FIG. 6 for example, the first lens 205a is supported by a first lens holder 226, and the second lens 205b is supported by a lens holder 223. Moreover, the laser resonator 206 is supported by a crystal holder 224, and the emission optical system 210 is supported by a third lens holder 225. Further, the optical fiber 204 is supported by a fiber holder 221.

On the periphery of each of the holders, external threads are formed. The first lens holder 226, the second lens holder 223, and the crystal holder 224 are accommodated inside a resonator housing. Inside the resonator housing, internal threads that correspond to the external threads of the holders are formed. The fiber holder 221 is screwed into the resonator housing from the -Z side end of the resonator housing, and the third lens holder 225 is screwed into the resonator housing from the +Z side end of the resonator housing. In the present embodiment, the holders can be moved in the Z-axis direction by turning the holders.

More specifically, the relative position of the first lens 205a can be adjusted in the Z-axis direction by turning the first lens holder 226. In a similar manner, the relative position of the second lens 205b can be adjusted in the Z-axis direction by turning the second lens holder 223. Further, the relative position of the laser resonator 206 can be adjusted in the Z-axis direction by turning the crystal holder 224.

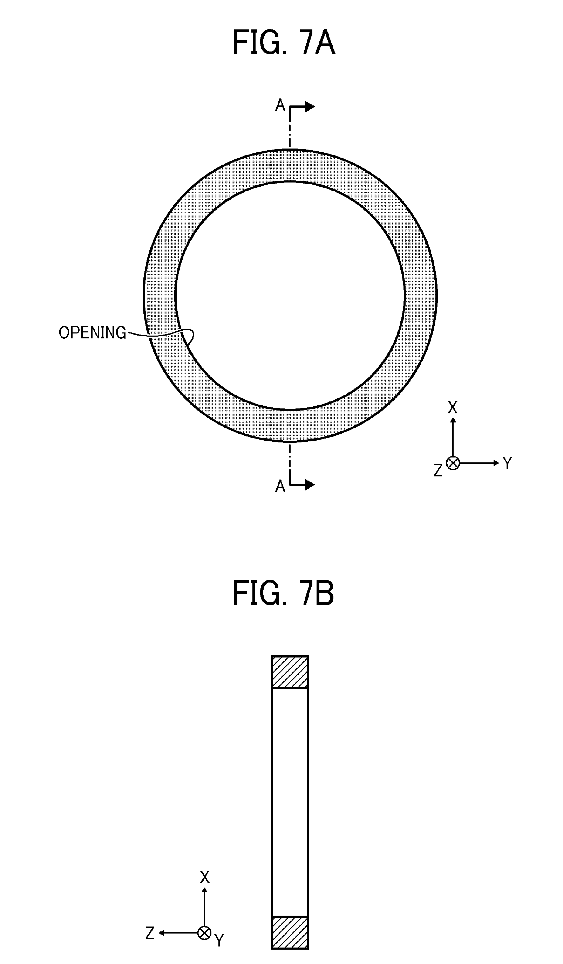

Each of the spacers is, as illustrated in FIG. 7A and FIG. 7B for example, a ringshaped plate that has an opening in the center such that the light can pass through. FIG. 7B is a sectional view A-A of FIG. 7A, according to the present example embodiment.

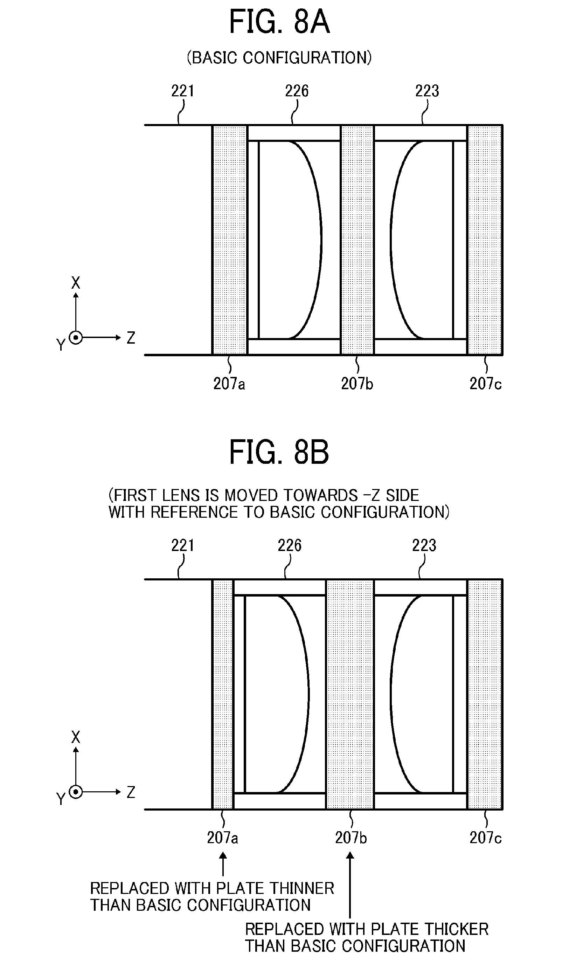

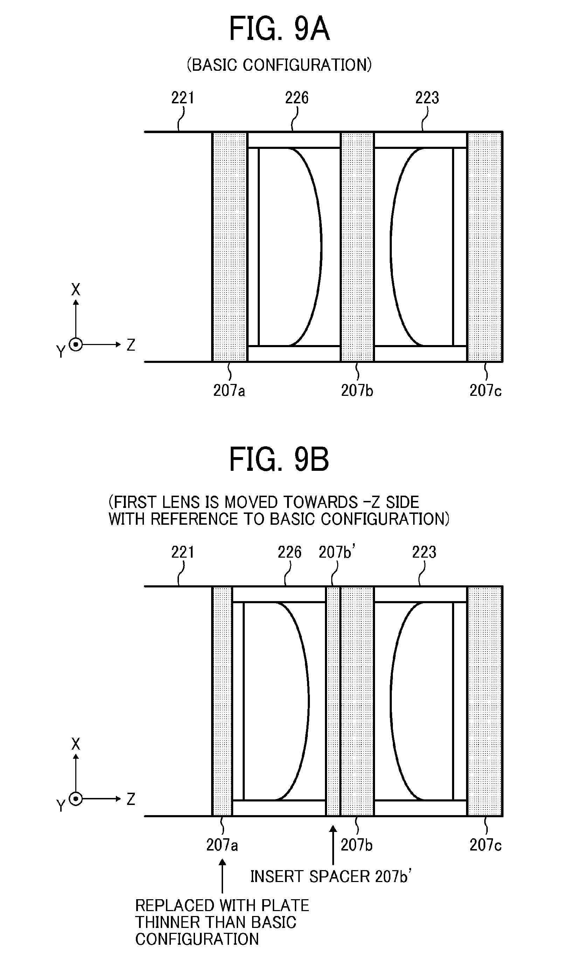

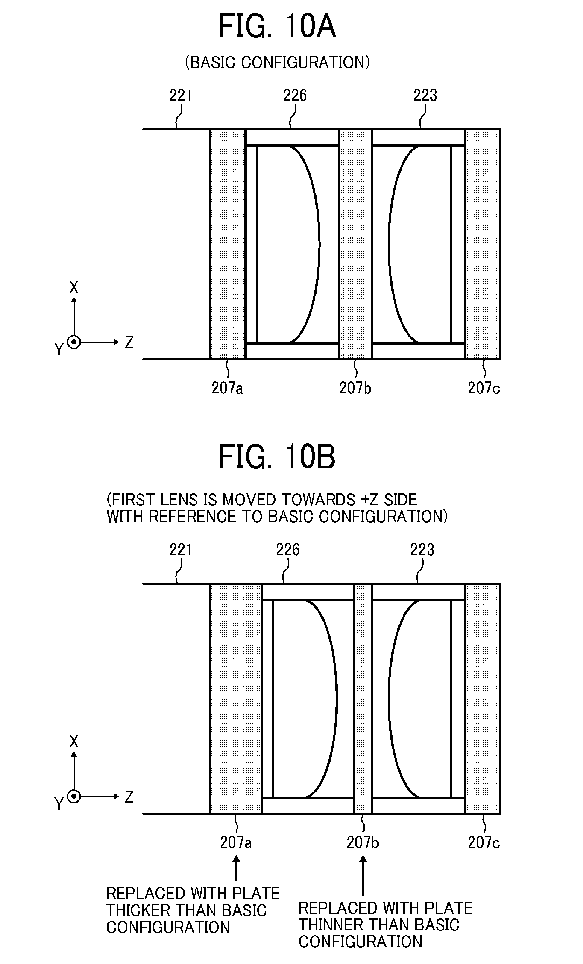

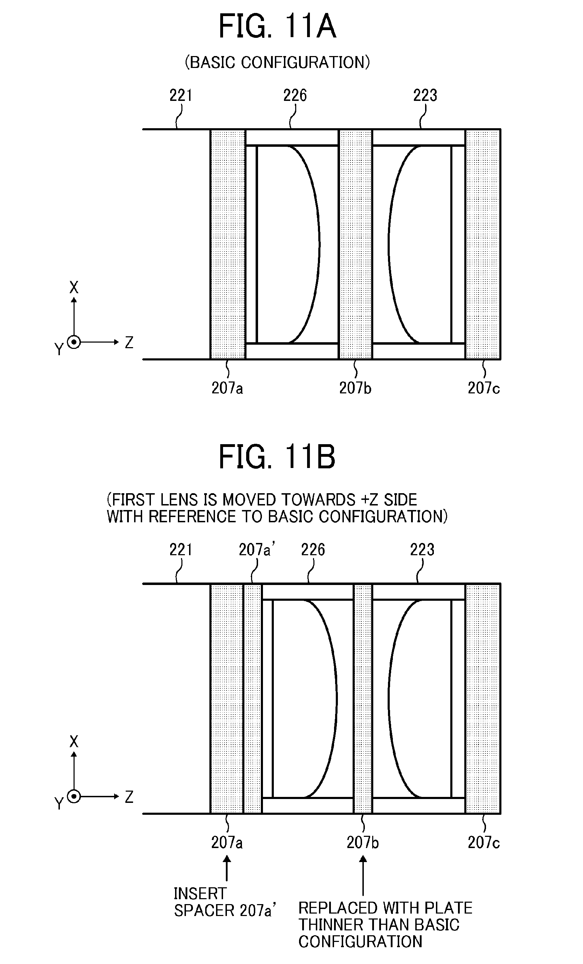

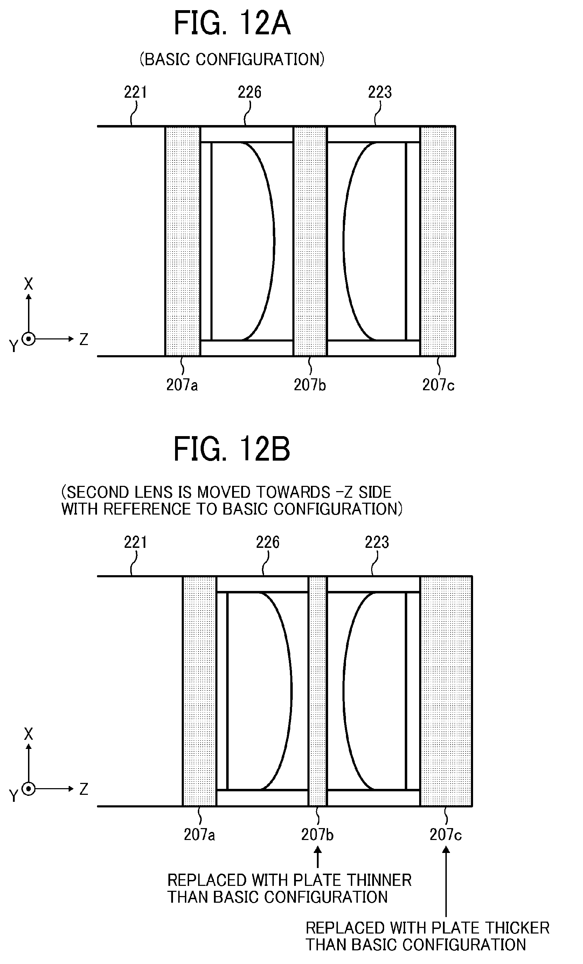

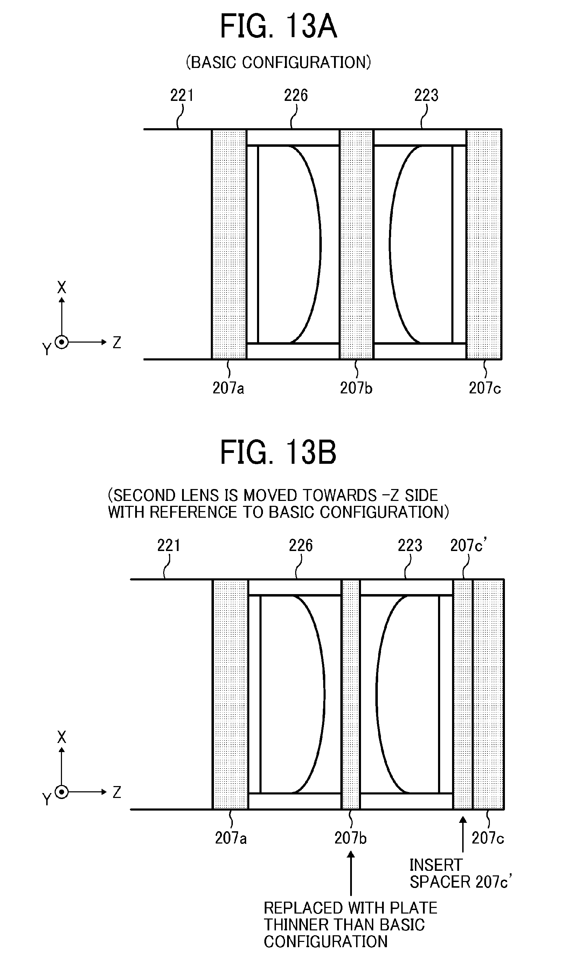

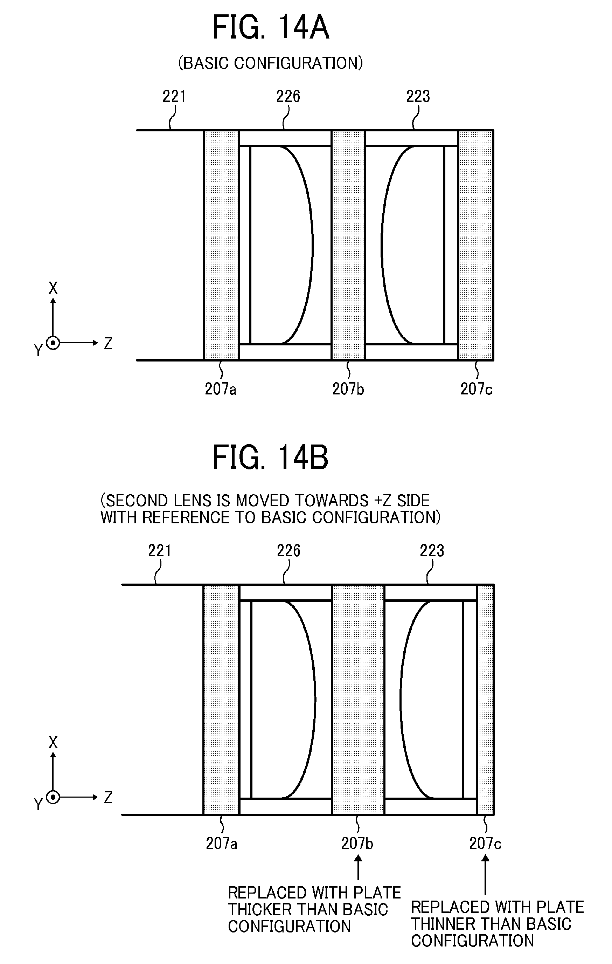

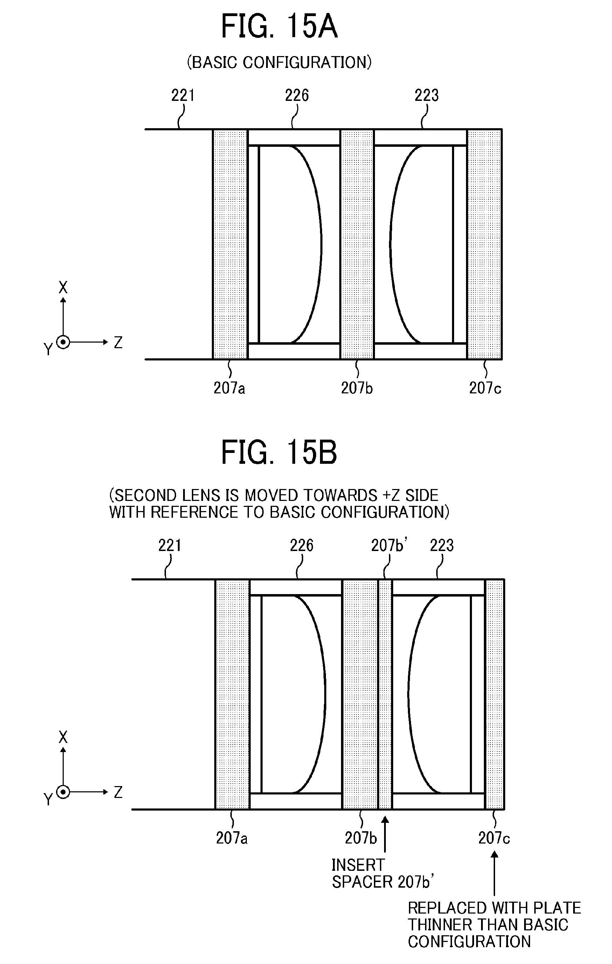

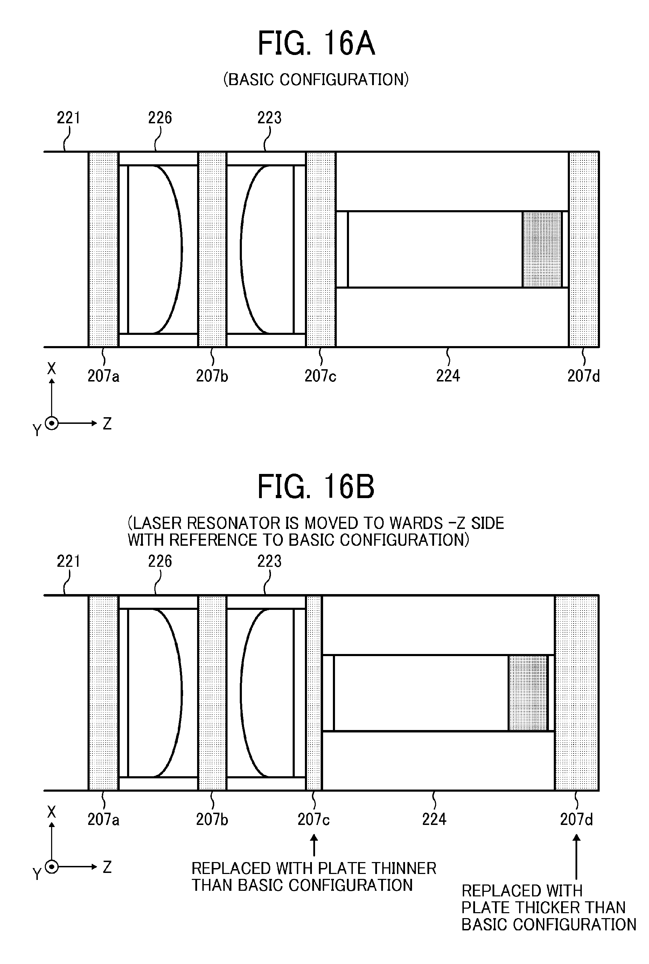

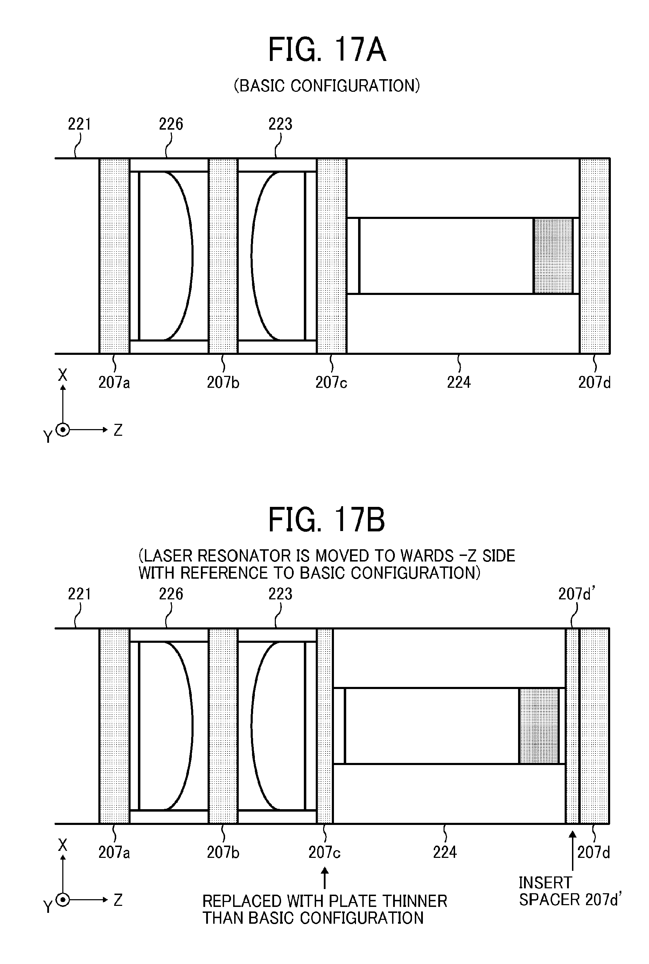

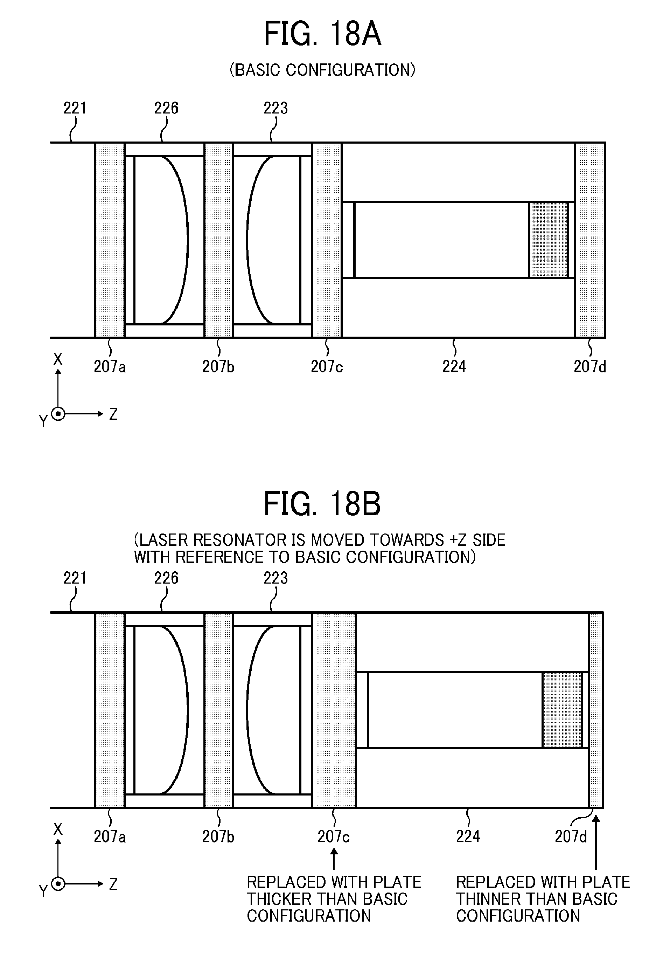

In the present example embodiment, a plate of stainless steel (SUS430 (Japanese Industrial Standards (JIS)) is used for the spacers. In a basic configuration of the present embodiment, the thickness of the spacer 207a, the thickness of the spacer 207b, the thickness of the spacer 207c, and the thickness of the spacer 207d are 1.32 millimeter (mm), 2.0 mm, 1.4 mm, and 1.0 mm, respectively. In the present embodiment, a plurality of plates with varying thickness are used.
(1) Cases in which a position of the first lens 205a is shifted towards the -Z side with reference to a basic configuration are described below.
   In such cases, as illustrated in FIG. 8A and FIG. 8B for example, the spacer 207a is replaced with a plate thinner than the basic configuration, and the spacer 207b is replaced with a plate thicker than the basic configuration.
   More specifically, when the moved distance is 0.5 mm for example, the spacer 207a is replaced with a plate with 0.82 mm thickness, and the spacer 207b is replaced with a plate with 2.5 mm thickness.
   Alternatively, as illustrated in FIG. 9A and FIG. 9B for example, the spacer 207a is replaced with a plate thinner than the basic configuration, and a spacer 207b' may be inserted between the first lens holder 226 and the spacer 207b of the basic configuration.
   More specifically, when the moved distance is 0.5 mm for example, the spacer 207a is replaced with a plate with 0.82 mm thickness, and a plate with 0.5 mm thickness is used as the spacer 207b'.
(2) Cases in which a position of the first lens 205a is shifted towards the +Z side with reference to a basic configuration are described below.
   In such cases, as illustrated in FIG. 10A and FIG. 10B for example, the spacer 207a is replaced with a plate thicker than the basic configuration, and the spacer 207b is replaced with a plate thinner than the basic configuration.
   More specifically, when the moved distance is 0.5 mm for example, the spacer 207a is replaced with a plate with 1.82 mm thickness, and the spacer 207b is replaced with a plate with 1.5 mm thickness.
   Alternatively, as illustrated in FIG. 11A and FIG. 11B for example, the spacer 207b is replaced with a plate thinner than the basic configuration, and a spacer 207a' may be inserted between the first lens holder 226 and the spacer 207a of the basic configuration.
   More specifically, when the moved distance is 0.5 mm for example, the spacer 207b is replaced with a plate with 1.5 mm thickness, and a plate with 0.5 mm thickness is used as the spacer 207a'.
(3) Cases in which a position of the second lens 205b is shifted towards the -Z side with reference to a basic configuration are described below.
   In such cases, as illustrated in FIG. 12A and FIG. 12B for example, the spacer 207b is replaced with a plate thicker than the basic configuration, and the spacer 207c is replaced with a plate thinner than the basic configuration.
   More specifically, when the moved distance is 0.5 mm for example, the spacer 207b is replaced with a plate with 1.5 mm thickness, and the spacer 207c is replaced with a plate with 1.9 mm thickness.
   Alternatively, as illustrated in FIG. 13A and FIG. 13B for example, the spacer 207b is replaced with a plate thinner than the basic configuration, and a spacer 207c' may be inserted between the second lens holder 223 and the spacer 207c of the basic configuration.
   More specifically, when the moved distance is 0.5 mm for example, the spacer 207b is replaced with a plate with 1.5 mm thickness, and a plate with 0.5 mm thickness is used as the spacer 207c'.
(4) Cases in which a position of the second lens 205b is shifted towards the +Z side with reference to a basic configuration are described below.
   In such cases, as illustrated in FIG. 14A and FIG. 14B for example, the spacer 207c is replaced with a plate thicker than the basic configuration, and the spacer 207b is replaced with a plate thinner than the basic configuration.
   More specifically, when the moved distance is 0.5 mm for example, the spacer 207c is replaced with a plate with 0.9 mm thickness, and the spacer 207b is replaced with a plate with 2.5 mm thickness.
   Alternatively, as illustrated in FIG. 15A and FIG. 15B for example, the spacer 207c is replaced with a plate thinner than the basic configuration, and a spacer 207b' may be inserted between the second lens holder 223 and the spacer 207b of the basic configuration.
   More specifically, when the moved distance is 0.5 mm for example, the spacer 207c is replaced with a plate with 0.9 mm thickness, and a plate with 0.5 mm thickness is used as the spacer 207b'.
(5) Cases in which a position of the laser resonator 206 is shifted towards the -Z side with reference to a basic configuration are described below.
   In such cases, as illustrated in FIG. 16A and FIG. 16B for example, the spacer 207c is replaced with a plate thinner than the basic configuration, and the spacer 207d is replaced with a plate thicker than the basic configuration.
   More specifically, when the moved distance is 0.5 mm for example, the spacer 207c is replaced with a plate with 0.9 mm thickness, and the spacer 207d is replaced with a plate with 1.5 mm thickness.
   Alternatively, as illustrated in FIG. 17A and FIG. 17B for example, the spacer 207c is replaced with a plate thinner than the basic configuration, and a spacer 207d' may be inserted between the crystal holder 224 and the spacer 207d of the basic configuration.
   More specifically, when the moved distance is 0.5 mm for example, the spacer 207c is replaced with a plate with 0.9 mm thickness, and a plate with 0.5 mm thickness is used as the spacer 207d'.
(6) Cases in which a position of the laser resonator 206 is shifted towards the +Z side with reference to a basic configuration are described below.
   In such cases, as illustrated in FIG. 18A and FIG. 18B for example, the spacer 207d is replaced with a plate thinner than the basic configuration, and the spacer 207c is replaced with a plate thicker than the basic configuration.
   More specifically, when the moved distance is 0.5 mm for example, the spacer 207d is replaced with a plate with 0.5 mm thickness, and the spacer 207c is replaced with a plate with 1.9 mm thickness.

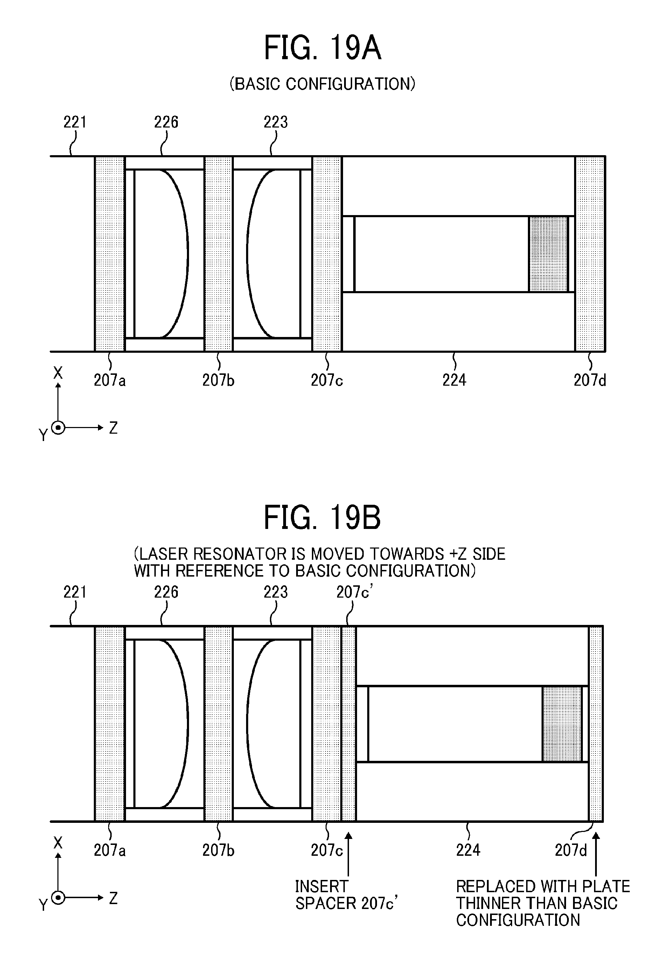

Alternatively, as illustrated in FIG. 19A and FIG. 19B for example, the spacer 207d is replaced with a plate thinner than the basic configuration, and a spacer 207c' may be inserted between the crystal holder 224 and the spacer 207c of the basic configuration.

More specifically, when the moved distance is 0.5 mm for example, the spacer 207d is replaced with a plate with 0.5 mm thickness, and a plate with 0.5 mm thickness is used as the spacer 207c'.

In the present embodiment, the Q-switched laser output and the number of light-emitting pulses are the characteristics of the light exited from the laser resonator 206, and the relative positions of the first lens 205a, the second lens 205b, and the laser resonator 206 are adjusted such that the Q-switched laser output and the number of light-emitting pulses reach desired values. In the present embodiment, the desired value for the number of light-emitting pulses is set to four per 500 microsecond (µs).

In the positioning described above, the distance between the +Z side lateral edge face of the optical fiber 204 and the first lens 205a may be adjusted within the range of about 3 mm. The distance between the first lens 205a and the second lens 205b may be adjusted within the range of about 10 mm. The distance between the second lens 205b and the laser resonator 206 may be adjusted within the range of about 5 mm. The distance between the laser resonator 206 and the emission optical system 210 may be adjusted within the range of about 50 mm. Note that each of the adjustable ranges described above is merely an example, and no limitation in limited thereby.

When the position of the second lens 205b is adjustable, the "distance between first surface to focal point" can be adjusted without adjusting any of the positions of the first lens 205a and the laser resonator 206.

The ignition system 301 for which the laser device 200 is provided has energy higher than that of any known ignition systems such as a spark plug, and the ignition point can be changed as desired. Accordingly, it is expected that the efficiency of the engine be improved.

As described above, with the laser device 200 according to the present embodiment, the second condensing optical system 205 serves as a plurality of optical elements, and the spacers 207a to 207c serve as an adjuster that adjusts the position of at least one of the optical elements. Moreover, the spacer 207c and the spacer 207d serve as an adjuster that adjusts the position of the laser resonator.

As described above, the laser device 200 according to the present embodiment includes the surface emitting laser array 201, the first condensing optical system 203, the optical fiber 204, the second condensing optical system 205 including a plurality of optical elements and the multiple spacers 207a to 207d, and the laser resonator 206.

The surface emitting laser array 201 includes a plurality of light-emitting units. The light that is emitted from the surface emitting laser array 201 is collected and condensed by the first condensing optical system 203, and propagates through the optical fiber 204. Then, the light is collected and condensed by the second condensing optical system 205, and enters the laser resonator 206.

The laser resonator 206 is a composite crystal of the laser medium 206a and the saturable absorber 206b. In such a composite crystal, the boundary between the laser medium 206a and the saturable absorber 206b is not split. Accordingly, such a composite crystal has characteristics similar to those of a single crystal, and has favorable mechanical strength and optical properties.

The multiple spacers 207a to 207d are used to adjust the relative positions of the optical elements of the second condensing optical system 205 and the laser resonator 206 in the Z-axis direction.

More specifically, in the laser device 200, a plurality of optical elements are disposed between the optical fiber 204 and the laser resonator 206, and an adjuster is provided that adjusts the relative positions of the optical elements and the laser resonator 206 in the Z-axis direction.

Accordingly, the "beam-waist diameter", "incidence angle", and the "distance between first surface to focal point" of the light that enters the laser resonator 206 can individually be adjusted with high accuracy. As a result, even when an error in assembly is present, Q-switched laser characteristics can be obtained as desired in a stable manner.

If the second condensing optical system 205 includes only one lens, it is difficult to individually adjust the "beam-waist diameter", "incidence angle", and the "distance between first surface to focal point" of the light that enters the laser resonator 206 with high accuracy by adjusting the relative position of the lens in the Z-axis direction.

Due to the provision of the laser device 200, the ignition system 301 according to the present embodiment can perform ignition in a stable manner. In the present embodiment, the focal point in the Z-axis direction can be controlled by adjusting the focal length of the emission optical system 210.

Due to the provision of the ignition system 301, the operation of the engine 300 according to the present embodiment can be stabilized.

In the embodiments described above, cases in which the material of spacers is stainless steel are described. However, no limitation is intended thereby.

In the embodiments described above, cases in which the outside shape of spacers is circular are described. However, no limitation is intended thereby. For example, the outside shape of spacers may be rectangular or elliptic.

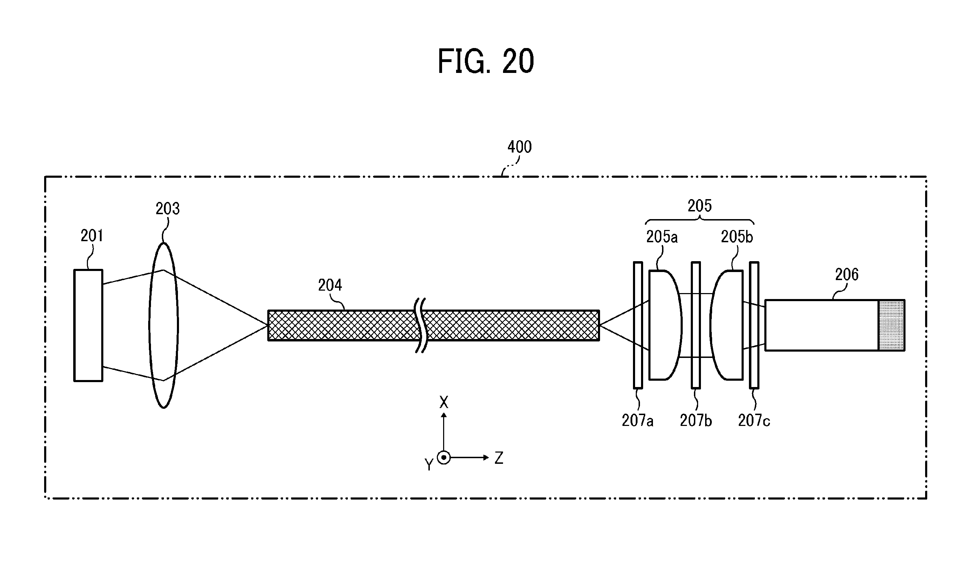

When it is not necessary to adjust the relative position of the laser resonator 206 in the embodiments described above, the spacer 207d may be omitted as in a laser device 400 illustrated in FIG. 20 for example.

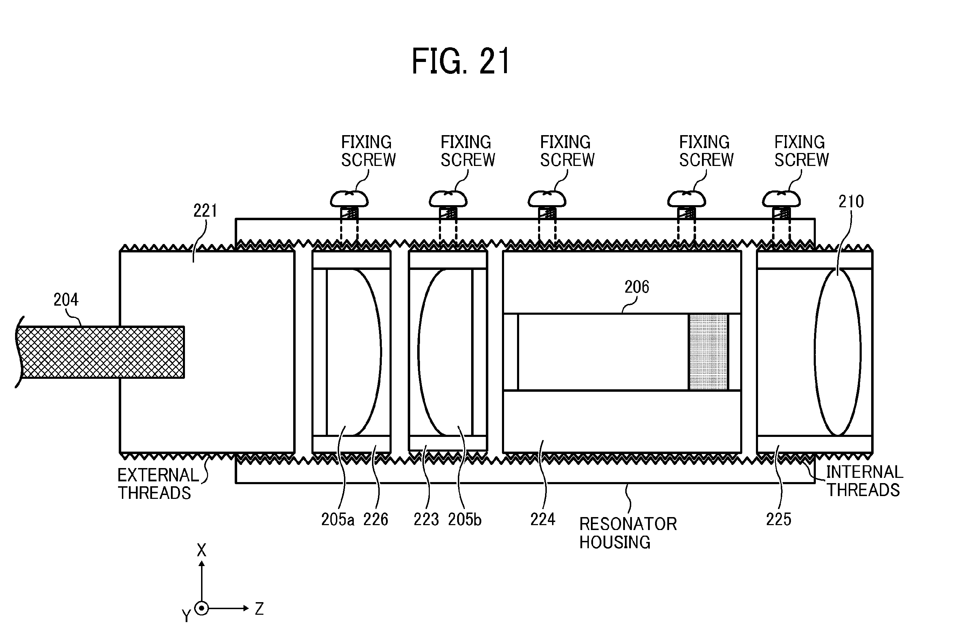

In the embodiments described above, cases in which the relative positions of the first lens 205a, the second lens 205b, and the laser resonator 206 are adjusted using spacers are described. However, no limitation is intended thereby. For example, as illustrated in FIG. 21, fixing screws may be used.

The fixing screws penetrate the resonator housing in the direction orthogonal to the Z axis, and the front ends of the screws face the holders. Accordingly, the holders are fixed to the resonator housing by fastening the fixing screws, and the fixation between the holders and the resonator housing is released by loosening the fixing screws. The fixing screws are loosened to adjust the relative positions of the holders, and are fastened when the adjustment is finished.

In the embodiments described above, cases in which relative positions are adjusted using spacers only in the Z-axis direction are described. However, no limitation is intended thereby. For example, spacers may be used to adjust relative positions in the X-axis direction or the Y-axis direction.

Numerous additional modifications and variations are possible in light of the above teachings. It is therefore to be understood that within the scope of the appended claims, the disclosure of the present invention may be practiced otherwise than as specifically described herein. For example, elements and/or features of different illustrative embodiments may be combined with each other and/or substituted for each other within the scope of this disclosure and appended claims.

## Claims

1. A laser device (200) comprising:
a light source (201) configured to emit light;
a light transmission member (204) configured to transmit the light emitted from the light source (201);
a plurality of optical elements (205) disposed in an optical path of the light transmitted by the light transmission member (204);
a laser resonator (206) which the light passed through the plurality of optical elements (205) enter; and
an adjuster (207) configured to adjust a position of at least one of the plurality of optical elements (205).

2. The laser device (200) according to claim 1, wherein one of the plurality of optical elements (205) is disposed closest to the laser resonator (206).

3. The laser device (200) according to claim 1 or 2, wherein the adjuster (207) adjusts a relative position of the laser resonator (206).

4. The laser device (200) according to claim 1 or 2, wherein the adjuster (207) includes an adjuster (207c, 207d, 207c', 207d') to adjust a relative position of at least one of the optical elements (205) and the laser resonator (206).

5. The laser device (200) according to claim 1 or 2, wherein the adjuster (207) includes an adjuster (207a, 207b, 207c, 207a', 207b', 207c') to adjust relative positions of two or more of the optical elements (205).

6. The laser device (200) according to claim 1 or 2, wherein the adjuster (207) includes an adjuster (207a, 207b, 207c, 207d, 207a', 207b', 207c', 207d') to adjust a relative position of at least one of the optical elements (205) and the light transmission member (204).

7. The laser device (200) according to any one of claims 1 to 6, wherein the light source (201) is a surface emitting laser.

8. The laser device (200) according to any one of claims 1 to 7, wherein the laser resonator (206) is a Q-switched laser.

9. The laser device (200) according to claim 8, wherein the laser resonator (206) is made of ceramic.

10. The laser device (200) according to claim 8 or 9, wherein the laser resonator (206) is a composite crystal in which a laser medium and a saturable absorber are bonded together.

11. The laser device (200) according to claim 10, wherein
the laser medium is a YAG crystal where Nd is doped, and
the saturable absorber is a YAG crystal where Cr is doped.

12. The laser device (200) according to any one of claims 1 to 11, wherein the light transmission member (204) is an optical fiber.

13. An ignition system (301) comprising:
the laser device (200) according to any one of claims 1 to 12; and
an optical system (210) configured to collect and condense the light emitted from the laser device (200).

14. An internal combustion engine (300) in which fuel is burnt to produce inflammable gas, the internal combustion engine (300) comprising: the ignition system (301) according to claim 13 which ignites the fuel.
